# EUROPEAN PATENT APPLICATION

(11) **EP 4 804 428 A1**
(43) Date of publication of application: **09.09.2026**
(21) Application number: 25315073.4
(22) Date of filing: 04.03.2025
(51) Int. Cl.: H04B 10/50, H01S 5/06, H01S 5/40, H04B 10/572, H04B 10/112

(54) **DEVICE FOR OPTICAL COMMUNICATIONS**

(71) Applicant: Nokia Solutions and Networks Oy, 02610 Espoo (FI)
(72) Inventor: Shen, Alexandre, 91400 Orsay (FR); Bourgon, Emmanuel, 91120 Palaiseau (FR); Md Adib, Mosaddek Hossain, 71638 Ludwigsburg (DE); Bigo, Sébastien, 91300 Massy (FR)
(74) Representative: Loyer & Abello

(57) **Abstract**

In an embodiment, the invention provides a device for optical communications, such as an optical transceiver or optical transmitter, comprising: a photonic integrated circuit including first and second semiconductor laser sources (2, 3) having a first and a second nominal wavelengths, wherein the first and second semiconductor laser sources are wavelength tunable, and
a thermal unit (7) thermally coupled to the first and second semiconductor laser sources to impose a shared temperature on the first and second semiconductor laser sources, so that the first and second semiconductor laser sources transmit a first and a second optical signals (12, 13) at a first and a second transmission wavelengths, wherein the first and second transmission wavelengths are identically shifted from the first and second nominal wavelengths as a function of the shared temperature. The device may further comprise a temperature controller (5) for controlling the thermal unit and a sensor (6) for sensing the shared temperature.

## Description

### Field of the invention

The invention relates to the field of devices used in optical communications, particularly to optical transmitters and optical transceivers suitable for Wavelength-division Multiplexing systems.

### Background

To respond to the growing needs of flow rates in the transmission of information, Wavelength-division Multiplexing systems (WDM) are used. WDM consists in combining a plurality of signals at different wavelengths in a single optical link, e.g. in an optical fiber or in free space. According to this method, the global flow rate of the optical link is the sum of the flows rates of all the signals. However, the wavelength of each signal should be controlled in emission and in reception to avoid unwanted signal interferences.

Tunable semiconductor laser sources are employed in WDM core networks. However, developments of WDM systems in access networks are contemplated,

### Summary

Embodiments according to the invention aim at providing cost-efficient tunable laser sources usable in various applications, e.g. WDM Passive Optical Networks (PON) or communications in free space.

In an embodiment, the invention provides a device for optical communications, comprising a photonic integrated circuit (PIC) including first and second semiconductor laser sources having a first and a second nominal wavelength, wherein the first and second semiconductor laser sources are wavelength tunable, and a tuning unit coupled to the first and second semiconductor laser sources to impose a shared wavelength control on the first and second semiconductor laser sources, so that the first and second semiconductor laser sources are caused to transmit respectively a first and a second optical signal at a respective first and a second transmission wavelength, wherein the first and second transmission wavelengths are identically shifted from the first and second nominal wavelengths as a function of the shared wavelength control.

Embodiments of the device may include one or more of the following features.

In an embodiment, the first and second semiconductor laser sources are wavelength tunable through thermo-optical effect, the tuning unit comprises a thermal unit thermally coupled to the first and second semiconductor laser sources and the shared wavelength control is a shared temperature.

In an embodiment, the first and a second optical signals are continuous waves.

In an embodiment, the device comprises a temperature controller for controlling the thermal unit and a sensor for sensing the shared temperature of the first and second semiconductor laser sources. The sensor may be connected to the temperature controller for providing a feedback signal to the temperature controller.

In embodiments, the sensor is arranged on the photonic integrated circuit at some distance from the laser sources, e.g. at an equal distance from the first and second semiconductor laser sources. In other words, the distance from the sensor can be equal for both laser sources. Multiple sensors can also be put in the device.

In an embodiment, the thermal unit comprises a Joule-effect heater arranged on the photonic integrated circuit between the first and second semiconductor laser sources.

In an embodiment, the thermal unit uses the thermoelectric effect, e.g., the thermal unit comprises a thermo-electric module, e.g. cooler and/or heater, overlaid on the photonic integrated circuit.

In an embodiment, the first and second semiconductor laser sources are Distributed Feedback (DFB) lasers having a first and a second grating period.

In an embodiment, the invention also provides an optical transceiver comprising the device, and further comprising an optical modulator coupled to the first semiconductor laser source for modulating the first optical signal at the first transmission wavelength, and a coherent optical receiver coupled to the second semiconductor laser source for employing the second optical signal at the second transmission wavelength as a local oscillator.

In an embodiment, the photonic integrated circuit further comprises the optical modulator and/or the coherent optical receiver.

In an embodiment, the optical modulator and the coherent optical receiver are configured for polarization-division-multiplexing (PDM).

In an embodiment, the invention also provides a communications terminal for a passive optical network, comprising the optical transceiver.

In an embodiment, the invention also provides an optical transmitter comprising the device, further comprising a first optical modulator coupled to the first semiconductor laser source for modulating the first optical signal at the first transmission wavelength, and a second optical modulator coupled to the second semiconductor laser source for modulating the second optical signal at the second transmission wavelength.

In an embodiment, the photonic integrated circuit further comprises the first optical modulator and/or the second optical modulator.

In an embodiment, the first optical modulator and the second optical modulator are configured for polarization-division-multiplexing (PDM).

In an embodiment of the optical transmitter, the photonic integrated circuit of the device further comprises first and second optical amplifiers arranged to amplify modulated first and second optical signals output by the first and second optical modulators.

In an embodiment, the optical transmitter further comprises optical amplifiers, e.g. Erbium-doped Fiber amplifiers (EDFA), coupled to the photonic integrated circuit to amplify modulated first and second optical signals output by the first and second optical modulators.

In an embodiment, the invention also provides a communications terminal for optical communications in free space, comprising the optical transmitter and a telescope arranged for sending out the modulated first and second optical signals in free space.

In an embodiment, the optical transmitter is a first optical transmitter and the communications terminal further comprises a second optical transmitter, wherein the first and second nominal wavelengths of the second optical transmitter are spectrally spaced from the first and second nominal wavelengths of the first optical transmitter, the communications terminal further comprising a wavelength multiplexer arranged for multiplexing the modulated first and second optical signals of the first and second optical transmitters, wherein the telescope arranged for sending out the multiplexed, modulated first and second optical signals of the first and second optical transmitters

Advantageous embodiments of such device, optical transceiver, optical transmitter and communications terminal are recited in the subclaims.

### Brief description of the drawings

These and other aspects of the invention will be apparent from and elucidated with reference to the embodiments described hereinafter, by way of example, with reference to the drawings.
- Figure 1 schematically illustrates a device according to an embodiment;
- Figure 1a schematically illustrates a device according to another embodiment;
- Figure 2 schematically illustrates an integrated dual-wavelength optical source according to an embodiment;
- Figure 3 schematically illustrates a coherent transceiver according to an embodiment;
- Figure 4 schematically illustrates a coherent transceiver according to another embodiment;
- Figure 5 schematically illustrates an optical transmitter according to an embodiment;
- Figure 6 schematically illustrates an optical transmitter according to another embodiment;
- Figure 7 schematically illustrates an optical transmitter according to yet another embodiment;
- Figure 8 schematically illustrates an optical transmitter according to yet another embodiment;
- Figure 9 schematically illustrates a communications terminal for optical communications in free space according to an embodiment;
- Figure 10 schematically illustrates a spectrum of optical signals that may be generated with the optical transmitter of Fig. 8.
- Figure 11 shows an embodiment of the device having a thermal unit in a top view and in a side view.
- Figure 12 shows another embodiment of the device having a thermal unit in a top view and in a side view.

### Detailed description of the embodiments

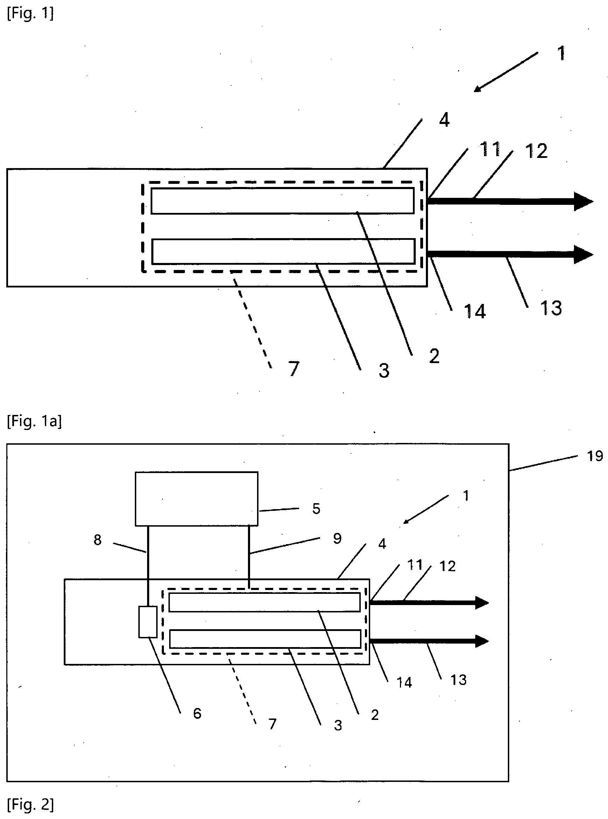

Fig. 1 illustrates a device 1 that may serve for different applications in optical communications as will be elucidated hereinbelow.

The device 1 comprises a photonic integrated circuit including a first and second semiconductor laser source. Both first and second semiconductor laser sources form an integrated dual wavelength source 4. The integrated dual wavelength source 4 thus includes a first semiconductor laser source 2 having a first nominal wavelength and a second semiconductor laser source 3 having a second nominal wavelength different from the first nominal wavelength. It should be noted that the Photonic integrated circuit, hereafter abbreviated by PIC can comprise more components apart from the integrated dual wavelength source 4. However, this is not illustrated here for sake of simplicity.

The first and second semiconductor laser sources 2 and 3 can be wavelength tunable, e.g. through thermo-optical effect, i.e. they may emit light at a slightly wavelength different from their nominal wavelength depending on a given wavelength control, e.g. the wavelength control may be a controlled variation of the actual temperature of the semiconductor laser source. The nominal wavelength can be defined as the center emission wavelength at room temperature, e.g. 25°C. The nominal wavelength of each semiconductor laser source depends on intrinsic features of the semiconductor laser source, e.g. materials, cavity length and so on.

Both semiconductor laser sources may preferably be integrated on a single platform or wafer made of any suitable material. A suitable platform is e.g. silicon on insulator, in which a silicon waveguide typically lies on top of a layer of silica and can be covered with silica. In other words, the Silicon waveguide can be embedded in a layer of silica (SiO₂).

The semiconductor laser sources 2 and 3 may be implemented in different manners. Preferably, the semiconductor laser sources 2 and 3 are DFB lasers having some different structural parameters, e.g. a different first and second period of the Bragg reflector. In an embodiment, the semiconductor laser sources 2 and 3 are DFB lasers with a specifically shaped Bragg section as disclosed by A. Gallet et al., "Design, Fabrication and Characterization of Hybrid III-V/SOI Phase-shift Free DFB Laser with Tapered Silicon Waveguide", ECOC 2018.

The semiconductor laser sources 2 and 3 could also be implemented as vertical-cavity surface-emitting lasers.

A tuning unit 7 is coupled to the semiconductor laser sources 2 and 3 to impose a shared wavelength control on the semiconductor laser sources 2 and 3. In embodiments relying on the thermo-optic effect, the tuning unit 7 is a thermal unit, which is thermally coupled to the semiconductor laser sources 2 and 3 to impose a shared temperature on the semiconductor laser sources 2 and 3. This ensures that the semiconductor laser source 2 transmits a first optical signal 12 at a first transmission wavelength and the semiconductor laser source 3 transmits a second optical signal 13 at a second transmission wavelength, such that the first and second transmission wavelengths are identically shifted from their first and second nominal wavelengths as a function of the shared temperature.

A typical thermal sensitivity of the transmission wavelengths is about 0.1nm/°C.

The thermal unit is preferably arranged in contact with the integrated dual wavelength source 4 itself i.e. directly on the photonic integrated circuit, or in contact with a printed circuit board (PCB) 19 as illustrated in Fig. 1a that carries the integrated dual wavelength source 4. The thermal unit may be implemented in different manners, e.g. as a cooler and/or a heater. In an embodiment the thermal unit comprises a thermo-electric module (TEM), which can operate either as a cooler or a heater depending on the direct or reverse bias current which applies on the TEM. The TEM may be overlaid on the photonic integrated circuit or on the circuit board 19. The circuit board 19 may be a PCB with high thermal conductivity.

In another embodiment, e.g. as shown in Fig. 2, the thermal unit comprises a Joule-effect heater 27 arranged on the photonic integrated circuit and situated between the semiconductor laser sources 22 and 23, preferably at an equal distance to both.

In yet another embodiment a Joule effect heater is arranged to modify the local temperature of the laser sources, and a larger TEM is arranged below a submount to stabilize the temperature of the whole PIC. The submount acts as a mechanical support for the laser.

Integrating both semiconductor laser sources 2 and 3 as a photonic integrated circuit provides a higher compacity and higher thermal conductivity which ensures a strong thermal coupling between both semiconductor laser sources. The strong thermal coupling between both semiconductor laser sources 2 and 3 promotes uniformity of the field of temperature across the semiconductor laser sources. As employed herein, a shared temperature means that mean value of the temperature witnessed by both semiconductor laser sources 2 and 3 has no difference higher than 0.5°C, preferably no temperature difference higher than 0.05 °C.

In the embodiment shown in Fig. 1a, the device 1 further comprises a temperature controller 5 for controlling the thermal unit, e.g. through a control line 9, and a sensor 6 for sensing the shared temperature of the semiconductor laser sources 2 and 3. For that purpose, the sensor 6 may be arranged on the photonic integrated circuit at an equal distance from the semiconductor laser sources 2 and 3. The sensor 6 is connected to the temperature controller 5 for providing a feedback signal to the temperature controller5, e.g. through a feedback line 8.

The location of sensor 6 on the PIC may depend on the available space. The design may vary in terms of position and size of the electrode pads for the laser sources, position and size of the heater or cooler, position and size of the pads for the sensor, and most-importantly position and size of all the electrical wiring.

Once the PIC is fabricated, including the thermal unit, the sensor 6 and their electrode pads, it may be necessary to calibrate the thermo-optical behavior of the whole subsystem to set a correct thermal control loop.

The temperature controller 5 may be arranged on the circuit board 19 next to the integrated dual wavelength source 4. The temperature controller 5 may also be arranged at a different location, e.g. on another circuit board not shown.

The temperature controller 5 may implement a control logic to control the thermal unit. The control logic may be based on a target temperature, a target emission wavelength or other schemes. The control logic may be software based or hardware based.

As earlier mentioned, Fig. 2 shows, an embodiment of device 1 comprising the integrated dual wavelength source 4. The semiconductor laser sources 22 and 23 are single-mode DFB lasers manufactured with known deposition and photo-lithographic techniques. Their mutual spacing may be as small as 80µm. Their length may range from a few 100µm to several mm, e.g. 1600 µm in one embodiment. A 90° dephasing section may be arranged in the middle of the DFB laser to render the DFB laser single-mode.

The device of this embodiment of Fig. 2 comprises a Joule-effect heater as well 27 which is arranged midway between the semiconductor laser sources 22 and 23, e.g. at a 40µm distance from each. The Joule-effect heater 27 may be realized as an elongated strip of resistive material, e.g. NiCr, that extends along the whole length of the semiconductor laser sources 22 and 23. The output ports 11 and 14 of the semiconductor laser sources 22 and 23 may be implemented as single polarization grating couplers for fiber ribbon coupling (250µm-pitch).

Electrical pads 20 are provided on the photonic integrated circuit for biasing the semiconductor laser sources 22 and 23 with electrical current injection, e.g. in a 50-500mA range.

Other electrical pads 29 are provided on the photonic integrated circuit for powering the Joule-effect heater 27. The electrical pads 29 may be connected to the temperature controller 5 (not shown on fig. 2). All the electrical pads can be aligned and put on one or several edges of the PIC.

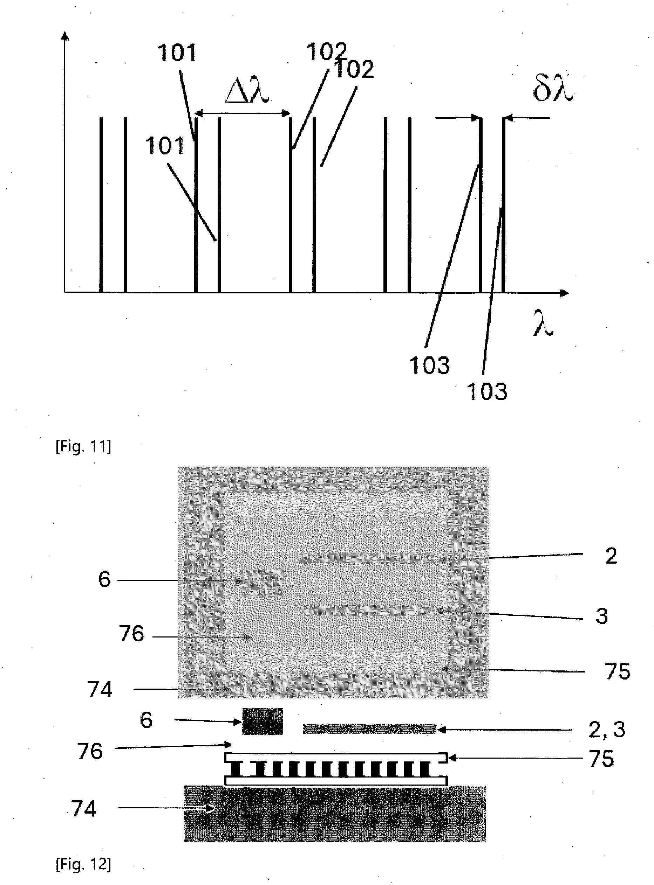

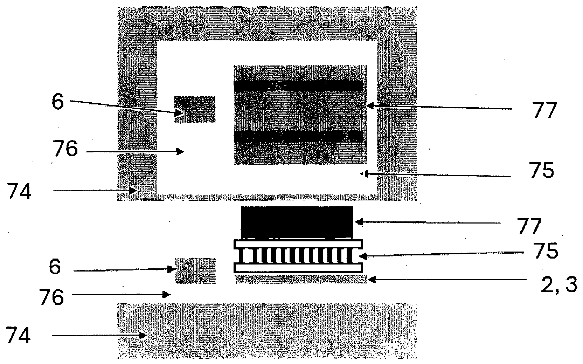

Referring to Fig. 11, the printed circuit board 74 carries a TEM 75 arranged directly between the printed circuit board 74 and the PIC. The PIC includes a silicon on insulator platform 76 that carries the semiconductor laser sources 2 and 3. The TEM 75 may have similar dimensions or larger dimensions than the silicon on insulator platform 76 to ensure a strong thermal coupling with the PIC. The sensor 6 is also arranged on the PIC.

Fig. 12 shows a variant of the device of Fig. 11. Here, the TEM 75 covers part or all of the silicon on insulator platform 76. A heat radiator 77 is arranged on top of the TEM 75 to facilitate heat dissipation.

The nominal wavelengths of the semiconductor laser sources 2 and 3 depicted in Figures 1 and 1a or 22 and 23 depicted in fig. 2 may be in the C-band or L-band. In an embodiment suitable for passive access networks, a difference between the first and second nominal wavelength may be between 0.8 and 50 nm.

In an embodiment suitable for satellite communications, a difference between the first and second nominal wavelength may be between 0.01 and 50 nm. In embodiments, a need may arise to discriminate a transmission wavelength and a reception wavelength because of a Doppler shift. The Doppler shift depends on the difference between the respective transmitter speed and receiver speed, which may vary as satellites circulate in their orbits. As satellites move, Doppler shift can get down to zero (temporarily), and then ramp up again as satellites move away from each other.

The device 1 may be employed for different applications.

Whereas thermo-optical effect is employed for wavelength tuning in the above described embodiments, it is also possible to control the wavelength of both laser sources by stabilizing the global temperature of the system or the subsystem containing the laser diodes and by using some other physical effect, e.g. electro-optical effect, plasma-refraction effect, Kerr effect, etc., to tune and control the wavelength of both laser diodes. The above-mentioned physical effect would act on a part of the laser intrinsic structure. Since those physical effects may simultaneously impact both laser sources in the same manner, they make it possible to control both laser sources so that the laser sources simultaneously shift their wavelength by the same quantity.

In embodiments relying on the electro-optical (EO) effect, i.e. dependency of the refractive index on an external electric field, the tuning unit 7 is an electrical tuning unit, which is electrically coupled to the semiconductor laser sources 2 and 3 to impose a shared external electrical field on the semiconductor laser sources 2 and 3. The external electrical field may be induced by a bias voltage applied on the semiconductor laser sources 2 and 3.

In an embodiment in which the semiconductor laser sources 2 and 3 are integrated on a Silicon Photonic (SiPh) platform, p-doped and n-doped Si it can be formed in the Si waveguide, which provide phase shift, using carrier depletion in a p-n junction. Here, the EO effect is also known as the plasma-dispersion effect. Also on a SiPh platform, one can use a p-i-n structure in which carrier injection causes the plasma-dispersion effect for the same purpose. In those embodiments, the tuning unit 7 is arranged to bias the p-n junctions or p-i-n junctions of both semiconductor laser sources 2 and 3 with the same electrical voltage.

In an embodiment in which the semiconductor laser sources 2 and 3 are integrated on a III-V on Thin Film Lithium Niobate (TFLN) platform, the EO effect of the lithium Niobate can be used, which relies on the high EO coefficient (r ~25-30pm/V) of the material.

It is noted that EO effect can be used independently from a thermo-optical effect or in combination with a thermo-optical effect. E.g. no significant thermal effect is generated as long as the injection current is small, e.g. for using carrier depletion in p-n junction where the carrier density is small. With a higher injection current, e.g. for injection current-induced plasma-dispersion effect in p-i-n junctions, a combined thermo-optical (TO) effect (i.e. Joule-effect induced heating) can also occur. As long as the p-i-n junctions are identical in both semiconductor laser sources 2 and 3, these combined EO- and TO-effects can add up and affect both lasers in an exact same way. Thus, the tuning unit 7 causes a shared wavelength control to be imposed also in this case.

In embodiments relying on the Magneto-optical effect, i.e. dependency of the refractive index on an external magnetic field, the tuning unit 7 is a magnetic tuning unit, which is electromagnetically coupled to the semiconductor laser sources 2 and 3 to impose a shared external magnetic field on the semiconductor laser sources 2 and 3.

### Coherent transceiver

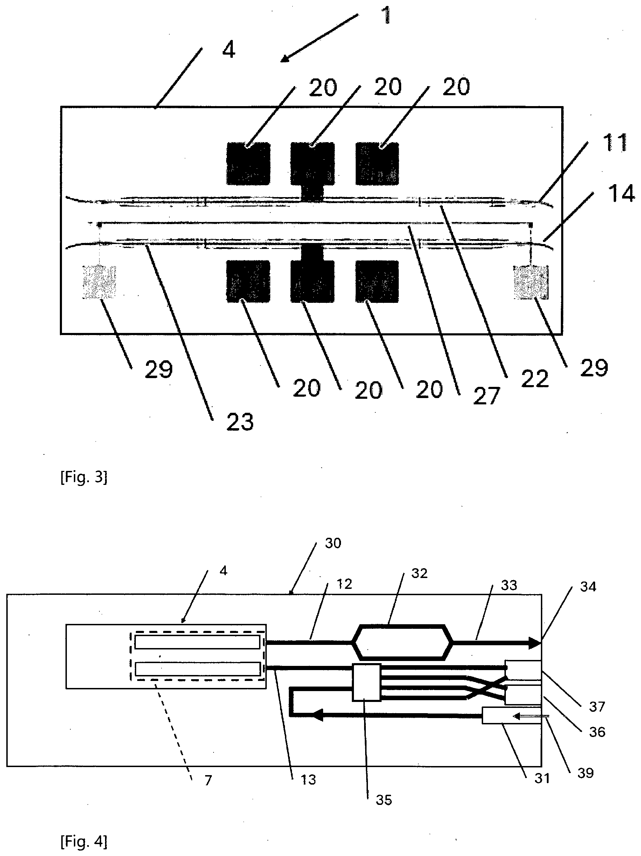

Embodiments in which the device is part of a coherent transceiver which may be employed for a very high-speed passive optical network (VHSP) or single-fiber coherent bidirectional application will now be described with reference to Figs. 3 and 4.

Coherent passive optical networks (PON) are seen with high expectation on receiver sensitivities, but with a challenging cost structure for access network applications. Currently, line rates in the range of 100 Gbit/s to 200 Gbit/s are analyzed. Therefore, a cost-efficient coherent transceiver as described herein may facilitate adoption of the coherent technology in PONs and short reach single-fiber Coherent bidirectional applications.

Figure 3 illustrates an optical transceiver implemented as a larger photonic integrated circuit, 30 that includes the integrated dual wavelength source 4 as well as the tuning unit 7 and further comprises:
- an optical modulator 32 coupled to the first semiconductor laser source for modulating the first optical signal 12 at the first transmission wavelength, and
- a coherent optical receiver 35, 36, 37 coupled to the second semiconductor laser source for employing the second optical signal 13 at the second transmission wavelength as a local oscillator.

More precisely, the optical modulator 32 is configured to provide a modulated optical signal 33 at the first transmission wavelength through an outport 34 of the PIC 30. If the PIC 30 is employed in an optical network unit (ONU) of the PON, the modulated optical signal 33 may serve as an upstream optical signal towards an Optical Line Terminal (OLT).

More precisely, in an embodiment the coherent optical receiver comprises a 90°-optical hybrid 35, two balanced photodiodes 36 and 37 and a polarization insensitive rendering circuit (PIRC) 31. The PIRC 31 makes it possible to detect a single polarization signal.

The second optical signal 13 serves as a local oscillator signal for being mixed in the 90°-optical hybrid 35 with an incoming optical signal 39 (i.e. downstream signal reaching the ONU) received through the PIRC 31.

The tuning unit 7of the integrated dual wavelength source 4 makes it possible to simultaneously tune the first and second transmission wavelengths.

If the manufacturing process employs partial testing to improve cost-efficiency, it may result in some dispersion of the nominal wavelengths of semiconductor laser sources 2 and 3. Hence the manufacturing process may be able to satisfy a specified wavelength window rather than a specified wavelength. Thermal tuning is an efficient way of coping with such dispersion.

While photonic integrated circuit 30 relates to a single polarization system, a coherent transceiver can be configured for a dual-polarization system as shown on Figure 4. For that purpose, the optical modulator and the coherent optical receiver are configured for polarization-division multiplexing.

Fig. 4 illustrates such an embodiment of an optical transceiver implemented as a photonic integrated circuit 40 that includes the integrated dual wavelength source 4 and the tuning unit 7 and:
- a dual polarization modulation circuit coupled to the first semiconductor laser source for modulating the first optical signal 12 at the first transmission wavelength, and
- a dual polarization coherent reception circuit coupled to the second semiconductor laser source for employing the second optical signal 13 at the second transmission wavelength as a local oscillator.

More precisely, the dual polarization modulation circuit comprises a beam splitter 41 for splitting the optical signal 12 into two equal optical signals for being fed into two respective modulators 42 and 43 for modulating the respective polarization components and a two-dimension Grating Coupler 44 for combining the modulated polarization components into the fiber as a dual polarization modulated optical signal 68. For example, a dual polarization in-phase and quadrature modulation scheme (DP-IQM) electrical signals can be fed into modulators 42 and 43 to perform E/O conversion. Both modulators 42 and 43 are IQ modulators (IQM): each of them will convert the electrical IQ signal into an optical IQ signal.

More precisely, the dual polarization coherent reception circuit comprises a two-dimensional Grating Coupler 45 for projecting the incoming optical signal 39 into two optical signals 38 representing the two orthogonal polarization components. Both optical signals 38 propagate in TE-mode in the PIC waveguides. So, the waveguides carrying the optical signals 38 coming from orthogonal polarization states in the input fiber 57 should never merge inside the PIC 40, so as to keep the information carried in the polarization channel. The dual polarization coherent reception circuit comprises a beam splitter for splitting and dividing the optical local oscillator signal 13 into two identical components, and two 90°-optical hybrids 46 for mixing the identical but divided local oscillator signal 13 and incoming optical signals 38, previously carried on orthogonal polarizations in the input fiber 57. A pair of balanced photodiodes 47 with a pair of associated transimpedance amplifiers 48 are connected to the output of each 90°-optical hybrid 46 to produce a detection signal 49, (and respectively 49a) representing the corresponding polarization component of the incoming signals.

Embodiments of a 2D-grating coupler are known, in the art (See for instance: https://www.researchgate.net/figure/Schematic-view-of-the-2-dimensional-grating-coupler-as-a-polarization-splitter-The-inset_fig1_334286568). Embodiments of a 90° Optical hybrid are known, in the art (See for instance: https://www.optoplex.com/90deg_Hybrid_Balanced_Receiver.htm)

As an example, a communications terminal for a passive optical network, e.g. an ONU or OLT may comprise the optical transceiver described herein.

In coherent PONs, the uplink and downlink wavelengths can drift due to a variety of causes, e.g. temperature, fabrication imperfections, and inappropriate laser settings. In the coherent transceiver as described herein, the local oscillator (LO) must follow the drifting wavelength of the input optical signal which has to be detected. In a coherent PON, an optical line terminal (OLT) broadcasts the downstream signal to multiples optical network units (ONU) in a point to multi-point topology. Therefore, the ONU LO can be tuned by changing the laser temperature, and it allows to detect the downstream signal. At the same time, the wavelength alignment can be synchronized in upstream direction thanks to the tuning unit 7.

In a first contemplated PON architecture, the ONU will employ the integrated dual-wavelength source 4: the first wavelength (λ1) will be used in upstream operation as a transmitter and the second wavelength (λ2) will be used in downstream operation as a LO. As an example A1 =1553nm may be used in the upstream direction and λ2=1546nm may be used as the LO in the downstream direction In this approach, the ONU will lock the LO signal (λ2) to the downstream incoming signal by changing the temperature. As mentioned before, the upstream signal (λ1) will automatically align with the LO of the OLT since the wavelength difference (δλ) of the integrated dual-wavelength source 4 is constant. In this architecture, the OLT may employ two different external cavity lasers.

The second contemplated PON architecture would employ the integrated dual-wavelength source 4 as a transmit laser and a LO laser in the OLT side in this architecture to reduce the system cost.

The specific wavelength difference (δλ) may be a standardized value, e.g. defined a standardization body such as ITU or IEEE.

### Optical transmitter

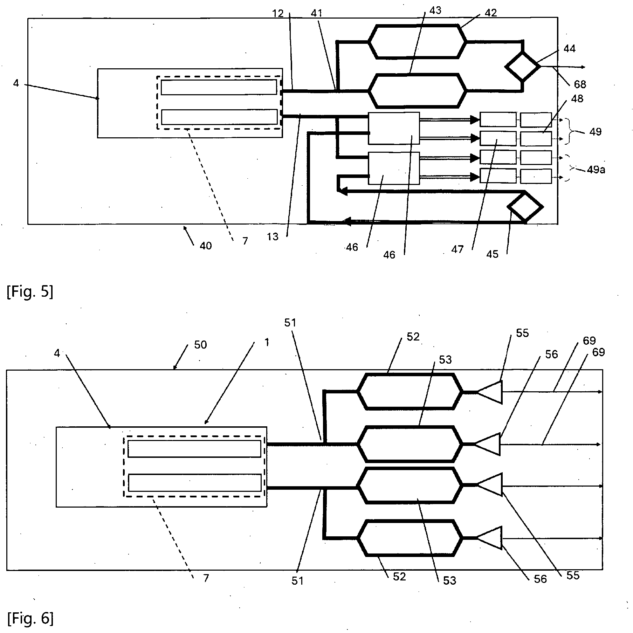

Turning now to Figures 5 to 10, embodiments in which the device is part of an optical transmitter will be described. The optical transmitter may be employed in free space communications, e.g. for satellite communications.

Fig. 5 illustrates an optical transmitter implemented as a photonic integrated circuit 50 that includes the integrated dual wavelength source 4 and tuning unit 7 and:
- a first optical modulator coupled to the first semiconductor laser source 2 for modulating the first optical signal at the first transmission wavelength, and
- a second optical modulator coupled to the second semiconductor laser source 3 for modulating the second optical signal at the second transmission wavelength.

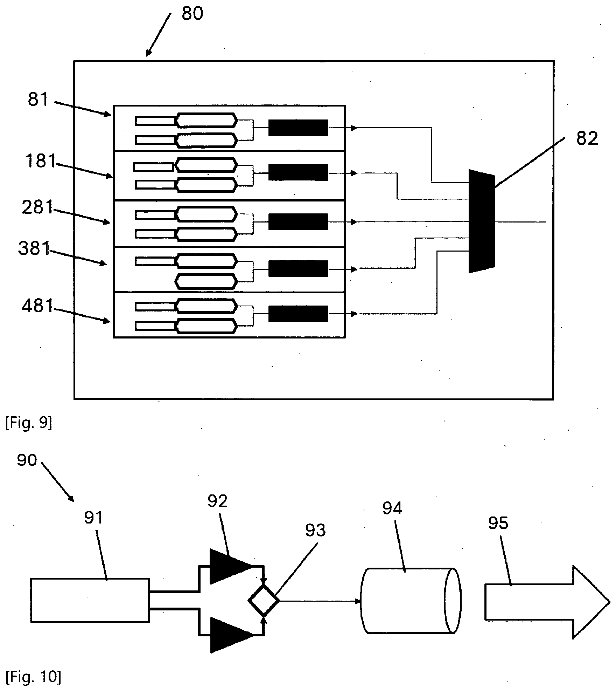

In Fig. 5, the first optical modulator and the second optical modulator are configured for performing polarization multiplexed communications. For that purpose, the optical transmitter comprises two beam splitters 51 for dividing each of the respective optical signals 12 and 13 (i.e. continuous waves (CW) from the integrated dual wavelength source 4 at the first and respectively second transmission wavelength) into two equal components. The optical transmitter thus also comprises two respective modulators 52 and 53 for modulating the respective optical signals 12 and 13 into modulated optical signals 69 and further comprises two one-dimensional Grating Couplers 55 and 56 for separately outputting the modulated optical signals 69. For example, a dual polarization in-phase and quadrature modulation (DP-IQM) format electrical signal 58 can be injected in modulators 52 and 53 and converted into optical signals.
- In a simpler embodiment without polarization multiplexing, a single modulator could be used for each wavelength. As further illustrated on Fig. 9, which shows an embodiment of a communications terminal for optical communications in free space, the polarization multiplexing may be implemented by a spatial combiner 93 outside the PIC 50, after signal amplification by EDFAs 92, before being sent through a telescope 94. In embodiments spatial combiner 93 can be a 2D-grating coupler or a free-space polarization beam combiner.

The embodiment of Fig. 6 is a variant. Elements identical to those of Fig. 5 bear the same numeral. However, instead of separately outputting optical signals for each polarization channel at each wavelength, which required four output couplers, the optical transmitter is implemented as a photonic integrated circuit 60 that includes a coupler 62 for combining the outputs of both modulators 52 and a coupler 62 for combining the outputs of both modulators 53. Namely the optical signals for a same polarization channel at two different wavelengths are multiplexed by each coupler 62. Therefore, each one-dimension Grating Coupler 55 or 56 outputs a WDM signal 59 for its respective polarization channel of the wavelength multiplexed signal. In this configuration, only two optical fibers are needed at the output of the PIC 60. Both WDM signals 59 will be amplified and polarization combined before being beamed through a telescope as further illustrated on Fig. 9.

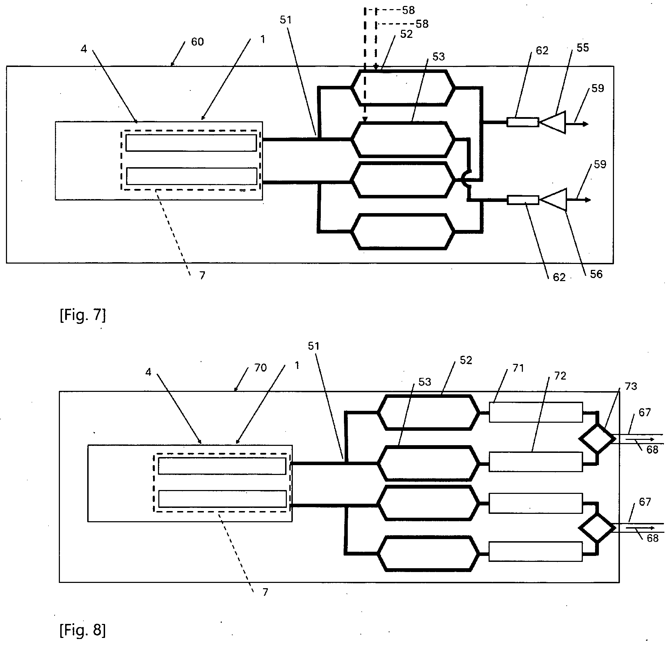

The embodiment of Fig. 7 is another variant. Elements identical to those of Fig. 5 bear the same numeral. The photonic integrated circuit 70 further comprises first amplifiers 71, 72 and second optical amplifiers 71, 72 arranged to amplify modulated optical signals output by the first modulator assembly and by the second optical modulator assembly.

More precisely, in this embodiment the optical transmitter is implemented as a photonic integrated circuit 70 that includes a respective semiconductor optical amplifier 71 at the output of each modulator 52 and a respective semiconductor optical amplifier 72 at the output of each modulator 53 for pre-amplification on the PIC. A respective two-dimension Grating Coupler 73 combines the modulated preamplified signals at each wavelength and each of the amplified signals is coupled into the single mode fiber 67 through two-dimension Grating Coupler 73 in its related polarization state to form a dual polarization modulated optical signal 68: the two polarization states in the optical fiber are orthogonal. In this configuration, two optical fibers 67 are needed at the output of the PIC 70. Alternatively, four outputs could be provided with one-dimension Grating Couplers instead, as in Fig. 5.

The embodiment of Fig. 8 is an optical transmitter implemented as a photonic integrated circuit 80 that includes a wavelength multiplexer 82. Integrating the wavelength multiplexer 82 in the same PIC facilitates temperature control of the wavelength multiplexer 82. The PIC 80 further includes a plurality of dual-wavelength optical transmitters 81, 181, 281, 381, 481 that may be made in accordance with any of the above-described embodiments. For the avoidance of collisions, it must be ensured that the pair of wavelengths output by each of the dual-wavelength optical transmitters 81, 181, 281, 381, 481 is sufficiently spaced from the pair of wavelengths output by any other of the dual-wavelength optical transmitters 81, 181, 281, 381, 481. Fig. 10 illustrates a suitable wavelength allocation for that purpose.

Fig. 10 illustrates a spectrum of optical signals that may be generated by the photonic integrated circuit 80. A first one of the dual-wavelength optical transmitters 81 outputs a pair of wavelengths 101, a second one 181 outputs a pair of wavelengths 102, a third one 281 outputs a pair of wavelengths 103 and so on. The wavelength difference (δλ) of each integrated dual-wavelength source 4 is much smaller than the gap (Δλ) between the respective pairs of wavelengths. This ensures that thermal tuning can be applied in each integrated dual-wavelength source 4 for compensating for some drift without spectral collision with another integrated dual-wavelength source 4.

Fig. 9 illustrates a communications terminal 90 for optical communications in free space, e.g. for optical communications from and/or to a satellite. It may send out at least one dual wavelength dual polarization modulated optical signal in free space. The communications terminal 90 comprises a PIC 91 forming an optical transmitter, which may be made in accordance with any of the above-described embodiments, e.g. PIC 50, PIC 60, PIC 70 or PIC 80.

Erbium-doped Fiber amplifiers (EDFA) 92 are coupled to the photonic integrated circuit 91 to amplify modulated first and second optical signals output by the first and second optical modulators or modulator assemblies. A spatial recombiner 93 combines the amplified optical signals into two orthogonal polarization states and a telescope 94 is arranged for sending out the modulated first and second optical signals 95 in free space.
- Whereas Fig. 9 illustrates a communications terminal for optical communications in free space according to an embodiment having a PIC 91 with two outputs and two EDFAs, it should be noted that four outputs with four EDFAs could be provided if the PIC 50 is employed or one output with one EDFA if the PIC 80 is employed. In addition, the EDFAs 92 could be omitted if amplification on the PIC provided sufficient power for the application.

For satellite communication, both pre-amplification on the PIC and external amplification is needed to generate sufficient power.

Optical fibers after the photonic integrated circuit 91 can be all Polarization-Maintaining (PM) fibers. The High Power EDFAs can be PM-based.

When used in combination with PIC 80, the communications terminal 90 comprises at least two dual-wavelength optical transmitters 81, 181 as a first optical transmitter and a second optical transmitter. As shown in Fig. 10, the first and second nominal wavelengths of the second optical transmitter may be spectrally spaced from the first and second nominal wavelengths of the first optical transmitter. The wavelength multiplexer 82 is arranged for multiplexing the modulated first and second optical signals of at least the first and second optical transmitters and the telescope 94 arranged for sending out the multiplexed, modulated first and second optical signals 95 of the first and second optical transmitters.

Whether or not the PIC 80 is used, the wavelength allocation illustrated by Fig. 10 is advantageous for satellite communications. Indeed, it provides almost twice the capacity of a system in which single channels are spaced by the large gap Δλ. In a satellite communication system, a typical spectral spacing is more than 100GHz frequency gap between the respective wavelength channels. This is due to the fact that drift of WDM channels is more difficult to control than on the ground.

By using paired channels generated by the integrated dual wavelength source described herein, the system capacity can be significantly increased because each pair of wavelength channels has a carefully controlled spacing δλ whereas pairs of channels can wander over a much larger range Δλ>> δλ. Naturally, further system capacity scaling can be obtained by designing a PIC with triplets or quadruplets of narrowly spaced wavelength sources on a single chip, still hosting a single thermal regulation stage for all.

The invention is not limited to the described embodiments. The appended claims are to be construed as embodying all modification and alternative constructions that may be occurred to one skilled in the art, which fairly fall within the basic teaching here, set forth.

The use of the verb "to comprise" or "to include" and its conjugations does not exclude the presence of elements or steps other than those stated in a claim. Furthermore, the use of the article "a" or "an" preceding an element or step does not exclude the presence of a plurality of such elements or steps.

In the claims, any reference signs placed between parentheses shall not be construed as limiting the scope of the claims.

## Claims

1. A device (1) for optical communications, comprising:
a photonic integrated circuit including first and second semiconductor laser sources (2, 3) having a first and a second nominal wavelength, wherein the first and second semiconductor laser sources are wavelength tunable, and
a tuning unit (7) coupled to the first and second semiconductor laser sources configured to impose a shared wavelength control on the first and second semiconductor laser sources, so that the first and second semiconductor laser sources are caused to transmit respectively a first and a second optical signal (12, 13) at a respective first and second transmission wavelength, wherein the first and second transmission wavelengths are identically shifted from the first and second nominal wavelengths as a function of the shared wavelength control.

2. The device according to claim 1, wherein the first and second semiconductor laser sources are wavelength tunable through thermo-optical effect, the tuning unit comprises a thermal unit (7) thermally coupled to the first and second semiconductor laser sources and the shared wavelength control is a shared temperature.

3. The device according to claim 2, further comprising a temperature controller (5) for controlling the thermal unit and a sensor (6) for sensing the shared temperature of the first and second semiconductor laser sources (2, 3), wherein the sensor (6) is connected to the temperature controller for providing a feedback signal to the temperature controller.

4. The device according to anyone of claims 2 to 3, wherein the thermal unit comprises a Joule-effect heater (27) arranged on the photonic integrated circuit between the first and second semiconductor laser sources (22, 23).

5. The device according to anyone of claims 2 to 3, wherein the thermal unit (7) comprises a thermo-electric module overlaid on the photonic integrated circuit.

6. The device according to anyone of claims 1 to 4, wherein the first and second semiconductor laser sources (2, 3) are DFB lasers having a first and a second grating period.

7. An optical transceiver (30) comprising the device (1) according to anyone of claims 1 to 6, and further comprising an optical modulator (32) coupled to the first semiconductor laser source for modulating the first optical signal (12) at the first transmission wavelength,
and further comprising a coherent optical receiver (31, 35, 36, 37) coupled to the second semiconductor laser source for employing the second optical signal (13) at the second transmission wavelength as a local oscillator.

8. The optical transceiver according to claim 7, wherein the optical modulator (42, 43) and the coherent optical receiver (45-49) are configured for polarization-division-multiplexing.

9. A communications terminal for a passive optical network, comprising the optical transceiver according to anyone of claims 7 to 8.

10. An optical transmitter comprising the device according to anyone of claims 1 to 6, further comprising a first optical modulator (52) coupled to the first semiconductor laser source for modulating the first optical signal (12) at the first transmission wavelength,
and a second optical modulator (53) coupled to the second semiconductor laser source for modulating the second optical signal (13) at the second transmission wavelength.

11. The optical transmitter according to claim 10, wherein the first optical modulator (52) and the second optical modulator (53) are configured for polarization-division-multiplexing.

12. The optical transmitter according to anyone of claims 10 to 11, wherein the photonic integrated circuit (70) of the device (1) further comprises first and second optical amplifiers (71, 72) arranged to amplify modulated first and second optical signals output by the first and second optical modulators (52, 53).

13. The optical transmitter according to anyone of claims 10 to 11, further comprising Erbium-doped Fiber amplifiers (92) coupled to the photonic integrated circuit (50, 60, 70, 80, 91) to amplify modulated first and second optical signals output by the first and second optical modulators (52, 53).

14. A communications terminal (90) for optical communications in free space, comprising the optical transmitter according to anyone of claims 10 to 13 and a telescope (94) arranged for sending out the modulated first and second optical signals (95) in free space.

15. The communications terminal (90) according to claim 14, wherein the optical transmitter according to anyone of claims 10 to 13 is a first optical transmitter (81), the communications terminal further comprising a second optical transmitter (181) according to anyone of claims 10 to 13, wherein the first and second nominal wavelengths of the second optical transmitter are spectrally spaced from the first and second nominal wavelengths of the first optical transmitter, the communications terminal further comprising a wavelength multiplexer (82) arranged for multiplexing the modulated first and second optical signals of the first and second optical transmitters (81, 181), wherein the telescope (94) arranged for sending out the multiplexed, modulated first and second optical signals (95) of the first and second optical transmitters.
